# EUROPÄISCHE PATENTSCHRIFT

(11) **EP 0 790 330 B1**
(45) Veröffentlichungstag und Bekanntmachung des Hinweises auf die Patenterteilung: **31.05.2000**
(21) Anmeldenummer: 97101694.4
(22) Anmeldetag: 04.02.1997
(51) Int. Cl.: C23C 14/50, C23C 14/56

(54) **Vorrichtung zum Transport von Substraten**
Apparatus for transporting substrates
Dispositif de transport de substrats

(30) Priorität: 15.02.1996 DE 19605599
(43) Veröffentlichungstag der Anmeldung: 20.08.1997
(73) Patentinhaber: Singulus Technologies AG, 63755 Alzenau (DE)
(72) Erfinder: Kempf, Stefan, 63755 Alzenau-Albstadt (DE)
(74) Vertreter: Heunemann, Dieter, Dr.

(56) Entgegenhaltungen:
- DE-U- 9 307 263

## Beschreibung

**Die Erfindung bezieht sich auf** eine Vorrichtung zum Transport von Substraten zwischen einer ersten und mindestens einer zweiten Vorrichtung zum Greifen und Halten von Substraten mit einem oder mehreren in einer Vakuumkammer angeordneten Substrathaltern.

**Es ist bereits eine Vorrichtung** zum Greifen und Halten eines scheibenförmigen Substrats bekannt (DE-U-93 07 263). Diese Vorrichtung besteht aus zahlreichen kreisförmig angeordneten Greifern und einer elastisch ausgebildeten Membrane, die in einem eine Öffnung aufweisenden, druckfesten Gehäuse angeordnet ist. Auf der Vorder- und Rückseite der Membrane können unterschiedliche Drücke eingestellt sein, und die Membrane kann so angeordnet sein, daß bei einem Differenzdruck eine Auslenkung der Membrane aus der Ruhelage erfolgt und bei Druckausgleich die Membrane über eine Druckfeder wieder in ihre Ruhelage zurückkehrt.

Der Differenzdruck an der Membrane wird dadurch erzeugt, daß auf der einen Seite der Membrane ein glokkenförmiges Gehäuse angeordnet ist, das mit einer zentralen Bohrung versehen ist. Zwischen dem Ende der Bohrung des glockenförmigen Gehäuses und der Oberfläche der Membrane wird ein Druckraum gebildet. Die in dem glockenförmigen Gehäuse vorgesehene Bohrung ist über eine pneumatische Leitung mit einer externen Pumpe versehen, die lediglich die Aufgabe hat, an der Oberfläche der Membrane einen Differenzdruck mit Bezug auf den in der darunterliegenden Kammer vorgesehenen Vakuumdruck herzustellen, so daß durch Druckbeaufschlagung der Membrane und ein an die Membrane anschließendes Stellteil der Greiferarm aus seiner das Substrat haltenden Stellung in eine weitere Stellung verstellbar ist, in der der oder die Greifer das Substrat freigeben. Eine derartige Vorrichtung ist aufwendig und teuer, da zur Erzeugung dieses Differenzdrucks eine besondere Pumpe erforderlich ist und die Membrane gegenüber dem Druck in der Vakuumkammer abgedichtet werden muß, um somit den notwendigen Druck an der Rückseite der Membrane erzeugen zu können. Außerdem ist eine derartige Anordnung sehr störanfällig, da die zusätzlich erforderliche Pumpe völlig abgekoppelt von den anderen Pumpen zur Erzeugung des Vakuumdrucks in der Vakuumkammer arbeitet, so daß keine ganz exakte Abstimmung auf den Arbeitsprozeß zum Verstellen der Membrane und der Abnahme des Substrats möglich ist. Insgesamt arbeitet eine derartige Vorrichtung relativ langsam, da die Freigabe des Substrats erst erfolgen kann, wenn der notwendige Systemdruck hinter der Membrane über die Fremdpumpe aufgebaut ist. Die Druckluftzuleitung muß flexibel zum Haltemechanismus angeordnet sein.

**Der Erfindung liegt die Aufgabe zugrunde**, eine mechanische oder elektromechanische sowie eine über Vakuumdruck steuerbare Vorrichtung zur Aufnahme von Substraten derart auszubilden und zueinander auszurichten, daß eine verzögerungsfreie und schnelle Übergabe des Substrats ohne Beeinträchtigung der Oberfläche des Substrats vorgenommen werden kann.

**Die Erfindung löst die Probleme dadurch**, daß die erste Vorrichtung zum Greifen und Halten von Substraten mit einem oder mehreren verstellbar angeordneten Greifern ausgerüstet ist, die mittels einer mechanischen und/oder elektromechanischen bzw. magnetisch arbeitenden Stelleinrichtung in eine das Substrat haltende bzw. freigebende Stellung verstellbar sind, wobei die zweite koaxial zur ersten ausgerichtete Vorrichtung zum Greifen und Halten von Substraten ebenfalls mit einem oder mehreren verstellbar angeordneten Greifern ausgerüstet ist.

Durch die vorteilhafte Zusammenführung der elektromechanischen Vorrichtung zum Greifen von Substraten mit der über Vakuumdruck steuerbaren Vorrichtung zum Greifen der Substrate wird ein störungsfreier Prozeßablauf zwischen den beiden Greifvorrichtungen gewährleistet und gleichzeitig auch sichergestellt, daß keine Beschädigung an der Oberfläche der Substrate erfolgt, da diese in die in den Substraten vorgesehenen Öffnungen eingreifen und auf diese Weise die Substrate in der gewünschten Position halten. Durch die elektromechanische Verstellvorrichtung und die zugehörigen Greifer, die mittels der Verstellvorrichtung eine Kippbewegung ausführen, kann das Substrat ohne weiteres in der hierfür vorgesehenen Öffnung erfaßt und gesichert werden, wozu die entsprechenden Greifer in eine vertikale Lage verstellt werden. Durch die Magneten erhält man eine optimale Stellkraft, die in Millisekunden die gewünschte Schwenkbewegung an den Greifern herbeiführt. Nach der Übergabe von einer Greifvorrichtung zu einer anderen wird über die Vakuumsteuerung der zweite Greifer zur Aufnahme des Substrats angesteuert, wobei hier in optimaler Weise der Vakuumdruck der zweiten Vakuumkammer eingesetzt und somit auf sämtliche Zusatzaggregate verzichtet werden kann. Auch diese zweite Greifvorrichtung arbeitet sehr exakt, und durch das Eingreifen dieser Greifer in die im Substrat vorgesehene Bohrung wird ebenfalls sichergestellt, daß die Oberfläche der Substrate in keiner Weise kontaktiert wird.

Hierzu ist es vorteilhaft, daß die Greifer gegen die Wirkung eines Stelldrucks bzw. gegen die Wirkung einer Feder in eine erste Stellung und über die Wirkung einer einem pneumatischen Druck Pₐ und/oder Vakuumdruck Pᵥ aussetzbaren Membrane und eines mit dieser zusammenwirkenden Stellteils in eine zweite Stellung verstellbar sind, wobei in der einen Stellung das Substrat gehalten und in der zweiten Stellung das Substrat für den Weitertransport gelöst wird, wobei in der Stellung der beiden Vorrichtungen zur Übergabe des Substrats die beiden Substrataufnahmeteile koaxial zueinander ausrichtbar und fixierbar sind, wobei nach koaxialer Ausrichtung und bei vakuumdichter Anlage der beiden Vorrichtungen der Druck in der Einschleuskammer abgesenkt und das über die erste Vorrichtung an die zweite Vorrichtung abgegebene Substrat mittels der zweiten Vorrichtung über den nun freiwerdenden Federdruck gehalten wird, und daß zwischen einem Drehteller der zweiten Vorrichtung und einem Substrathalter ein einen Hub zulassendes, federelastisches Verbindungselement vorgesehen ist.

Eine zusätzliche Möglichkeit ist gemäß einer Weiterbildung der erfindungsgemäßen Vorrichtung, daß das Verbindungselement aus einem mittleren Flansch besteht, der über Verbindungselemente mit dem Substrathalter und über elastische Stege mit dem Drehteller verbunden ist, daß die der ersten Vorrichtung zugeordneten Greifer mittels eines Stellelements bzw. Magnets und/oder Federelementen um eine Achse zwischen einer das Substrat haltenden und einer das Substrat freigebenden Stellung verschwenkbar sind und daß die der ersten Vorrichtung zugeordneten Greifer um eine Achse schwenkbar sind, die die Längsachse des Greifers oder des Gehäuses in einem annähernd rechten Winkel schneidet.

Vorteilhaft ist es ferner, daß die der ersten Vorrichtung zugeordneten Greifer bereits beim Fluten der Einschleuskammer ansprechen und die Greifer der zweiten Vorrichtung über den E-Magneten in eine Aufnahmestellung verstellt sind, und daß zwei oder mehrere mit Abstand zueinander angeordnete Greifer der ersten Vorrichtung bei der Substratübergabe in die Zwischenräume der ebenfalls mit Abstand zueinander angeordneten Greifer der zweiten Vorrichtung eingreifen. Durch den exakt steuerbaren Prozeßablauf und die genaue Abstimmung der beiden zusammenwirkenden Greifvorrichtungen läßt sich eine exakte Weitergabe des Substrats von der einen zu der anderen Vorrichtung durchführen, wobei hierzu mit einem Minimum an Bauteilen ausgekommen werden kann.

In weiterer Ausgestaltung der Erfindung ist es vorteilhaft, daß die Greifer im Bereich ihres einen Endes in Langlochöffnungen geführt sind und im Bereich ihres anderen Endes in einem Zylindergehäuse mindestens einen Dauermagneten aufweisen, der mit einem Ringmagneten zusammenwirkt. Durch Verwendung der länglichen, relativ schmal ausgebildeten Greifer zur Aufnahme der Substrate lassen sich entsprechende Zwischenräume zwischen den einzelnen Substrathaltern schaffen, so daß zwei zusammenwirkende Vorrichtungen sehr dicht aneinander herangefahren werden können, um eine exakte Übergabe der Substrate zwischen den beiden Vorrichtungen zu gewährleisten.

Eine zusätzliche Möglichkeit ist gemäß einer Weiterbildung der erfindungsgemäßen Vorrichtung, daß das Zylindergehäuse dünnwandig ausgebildet ist und eine Wandstärke zwischen 0,2 mm und 0,8 mm bzw. 0,3 mm und 0,7 mm bzw. 0,4 mm und 0,6 mm aufweist.

Vorteilhaft ist es ferner, daß die Greifer in einem elastischen Ringlager schwenkbar aufgenommen und im Bereich ihres oberen Endes zwischen magnetisierbaren Anschlägen verstellbar sind.

Ferner ist es vorteilhaft, daß die einem in etwa konstanten Vakuumdruck Pᵥ auf einer Seite ausgesetzte Membrane über einen Differenzdruck P_{d} = Pₐ - Pᵥ steuerbar ist, der dann auftritt, wenn die Kammer zur Aufnahme des Substrats geflutet wird.

Eine zusätzliche Möglichkeit ist gemäß einer Weiterbildung der erfindungsgemäßen Vorrichtung, daß die Membrane über den Atmosphären- und/oder Vakuumdruck bzw. den Differenzdruck P_{d}, der sich aus dem Atmosphärendruck Pₐ in der Einschleuskammer abzüglich des Vakuumdrucks Pᵥ in der Vakuumkammer ergibt, steuerbar ist. Durch die vorteilhafte Anordnung der Membrane, die in die Vakuumkammer hineinragt, kann erstmalig auf einfache Weise der in der Kammer auftretende Vakuumdruck als Stellgröße zum Verstellen der Membrane eingesetzt werden.

In weiterer Ausgestaltung der Erfindung ist es vorteilhaft, daß die in der Vakuumkammer angeordnete Membrane aus einem flexiblen und einem nicht flexiblen Teil bzw. einem Metallteil bzw. Teller gebildet ist. Durch Verwendung eines flexiblen und eines nicht flexiblen Teils zur Bildung der Membrane wird eine exakte Führung des Stellteils zum Verstellen bzw. Verschwenkung der Greifer geschaffen.

Gemäß einer bevorzugten Ausführungsform der erfindungsgemäßen Lösung ist schließlich vorgesehen, daß der nicht flexible Teil mit dem flexiblen Teil der Membrane fest verbunden ist und daß der nicht flexible Teil als kreisrunder Teller ausgebildet ist, der eine Öffnung der Membrane abdeckt.

Vorteilhaft ist es ferner, daß der flexible Teil der Membrane mit seinem äußeren Rand an einen Flansch der Vorrichtung und mit dem innenliegenden Rand an den Rand der im Teller vorgesehenen Öffnung fest angeschlossen ist und daß die Membrane und der Teller die einem ständigen Vakuumdruck Pᵥ ausgesetzte Kammer gegenüber der einem Atmosphärendruck Pₐ aussetzbaren Kammer bzw. Einschleuskammer abdichten.

Außerdem ist es vorteilhaft, daß der äußere Rand der Membrane in mindestens einer zwischen dem Flansch und dem Außenteil des Substrathalters vorgesehenen Nut einklemmbar und sicherbar ist und daß der Teller über einen koaxialen Zapfen mit einem zylinderförmigen Teil verbunden bzw. verschraubt ist, das auf einem mit einem ebenfalls koaxial angeordneten Flansch verbundenen Zapfen geführt ist. Durch die Verwendung einer Nut zur Aufnahme des äußeren Randes der Membrane erhält man eine sehr einfache Befestigungsart für die Membrane, die außerdem eine hohe Dichtigkeit gegenüber der gefluteten Kammer und der Vakuumkammer aufweist. Da der Teller über einen koaxialen Zapfen mit dem zylinderförmigen Teil verbunden bzw. verschraubt ist, kann bei Beschädigung der Membrane diese ohne weiteres gelöst werden. Hierzu braucht lediglich der Teller abgeschraubt und die Klemmverbindung der Membrane gelöst zu werden. Danach lassen sich diese Teile ohne weiteres ersetzen.

Ferner ist es vorteilhaft, daß das zylinderförmige Teil mit dem Stellteil fest verbunden ist und daß das Stellteil im Bereich seines einen Endes gegen einen oder mehrere Greifer anliegt.

Eine zusätzliche Möglichkeit ist gemäß einer Weiterbildung der erfindungsgemäßen Vorrichtung, daß das zylinderförmige Teil mit seinem einen oder zweiten Ende bzw. seinem Teller gegen einen feststehenden Flansch und mit seinem ersten oder anderen Ende bzw. Stellteil gegen den Greifer bzw. Hebelarm des Greifers anlegbar ist und daß sich bei auftretendem Differenzdruck P_{d} die Membrane weiter in den Vakuumraum bewegt und dabei den oder die Greifer vom Bohrungsrand des Substrats wegbewegt und diese freigibt.

In weiterer Ausgestaltung der Erfindung ist es vorteilhaft, daß der feststehende Flansch mit dem Flansch der Vorrichtung mittel- oder unmittelbar fest verbunden ist und eine zylinderförmige Verlängerung aufweist, in der die Feder aufgenommen ist. Durch die Verwendung einer zylinderförmigen Verlängerung auf dem feststehenden Flansch wird eine gute Führung der Feder gewährleistet und gleichzeitig sichergestellt, daß bei Druckausgleich zwischen den beiden Kammern ein sofortiges Verstellen der Greifer erfolgt.

Von Vorteil ist es ferner, daß zwischen dem Flansch der Vorrichtung und dem feststehenden Flansch ein Tragteil zur verschwenkbaren Aufnahme der Greifer vorgesehen ist und daß der feststehende Flansch und das Tragteil über die gleichen Verbindungselemente mit dem Flansch der Vorrichtung lösbar verbunden sind. Da das Tragteil zur Aufnahme der Greifer zwischen den beiden Flanschen angeordnet ist, erhält man eine sehr gute, einfache Fixierung der Halterung.

Eine wesentlich vorteilhafte Ausführungsform erreicht man dadurch, daß die oberhalb der Membrane liegende Kammer bzw. die Einschleuskammer über eine erste Vakuumpumpe evakuiert und über eine weitere Einrichtung geflutet und die unterhalb der Membrane liegende Kammer über eine zweite Vakuumpumpe evakuiert wird, wobei die beiden Vakuumpumpen bzw. die zugehörigen Ventile derart steuerbar sind, daß der Differenzdruck P_{d} auf annähernd Null herabsenkbar ist, und daß die obere Kammer, die über eine Einrichtung bzw. über ein Steuerventil geflutet wird, dadurch zwangsweise das sofortige Verstellen der Greifer einleitet.

**Weitere Vorteile und Einzelheiten der Erfindung sind in den Patentansprüchen** und in der Beschreibung erläutert und in den Figuren dargestellt, wobei bemerkt wird, daß alle Einzelmerkmale und alle Kombinationen von Einzelmerkmalen erfindungswesentlich sind. Es zeigt:
- Figur 1: eine schematische Darstellung des Funktionsablaufs der Gesamtvorrichtung einer Sputteranlage,
- Figur 2: eine perspektivische Darstellung einer Vorrichtung zum Beschichten von Compact Disks,
- Figur 3: eine Vorrichtung zum Greifen und Halten eines flachen, vorzugsweise scheibenförmigen Substrats,
- Figur 4: eine Schnittdarstellung eines ersten Substratgreifers mit einer elektromagnetisch wirkenden Stellvorrichtung,
- Figur 5: eine schematische Darstellung der Greifer von beiden Vorrichtungen in einer Ansicht von unten,
- Figur 6: die Gesamtvorrichtung zur Übergabe der Substrate von einer Vorrichtung mit der elektromagnetischen Stellvorrichtung an die zweite Vorrichtung mit über Vakuum steuerbaren Greifern,
- Figur 7: eine membranartige Feder zwischen einem Drehteller und einem Substrathalter gemäß Figur 6.

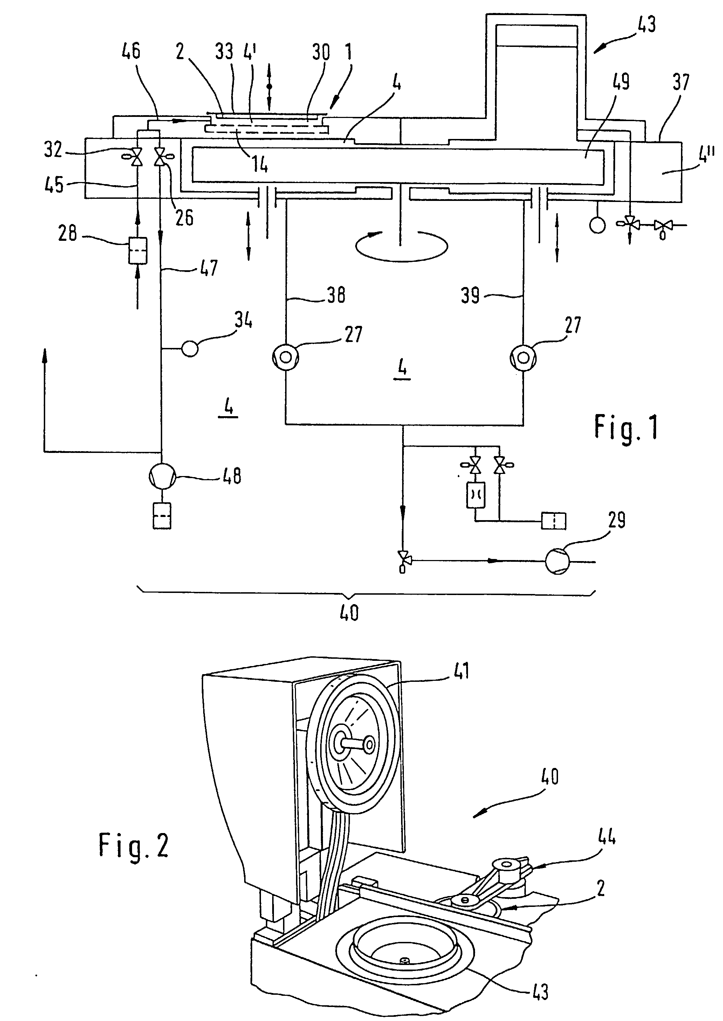

In der Zeichnung ist in Figur 2 eine perspektivische Darstellung eines oberen Teils einer Sputteranlage 40 wiedergegeben, zu dem ein um 180° drehbar gelagerter Greiferarm 44 gehört, mittels dessen die in Figur 2 mit 2 bezeichneten Substrate bzw. Compact Disks (CD) einer Vorrichtung 1 zum Greifen von Substraten (Disk-Receiver) zugeführt werden. Über diese Vorrichtung 1 gelangen die Substrate zu einer Prozeßstation 43, zu der auch eine in Figur 2 in einer geöffneten Stellung wiedergegebene Kathode 41 gehört.

In Figur 1 ist das Funktionsschema der Sputteranlage 40 mit den wesentlichen Vorrichtungsteilen wiedergegeben.

Das Substrat 2 wird mittels des Greiferarms 44 und eines zugehörigen Tellers 33, zu dem ebenfalls eine in Figur 1 nicht dargestellte Greifvorrichtung gehört, einer weiteren Vorrichtung zum Greifen von Substraten aufgegeben. In Figur 1 befindet sich der Teller 33 oberhalb eines Tellers bzw. Substrataufnahmeteils 14. In der Stellung gemäß Figur 1 sind die beiden Teller 33 und 14 koaxial zueinander ausgerichtet, so daß das Substrat 2 von dem Teller 33 dem Substrataufnahmeteil 14 aufgegeben werden kann.

In der Stellung gemäß Figur 1 ist der Teller 14 nach oben gefahren und dichtet ein ringförmiges Volumen bzw. eine Einschleuskammer 30 ab. Die Einschleuskammer 30 befindet sich zwischen dem oberen Teller 33 und dem unteren Teller bzw. Substrataufnahmeteil 14. Die am Teller 33 vorgesehenen, in Fig. 1 nicht dargestellten Greifelemente halten die Compact Disk oberhalb des Substrataufnahmeteils 14.

Die Einschleuskammer 30 kann über einen Filter 28 geflutet werden, der hierzu über eine Leitung 45 mit einem Ventil 32 verbunden ist, das über eine weitere Leitung 46 an die Einschleuskammer 30 angeschlossen ist. Durch Öffnen des Ventils 32 wird die Einschleuskammer 30 geflutet. Nachdem die Einschleuskammer 30 geflutet ist, wird der obere Teller angehoben, so daß das Substrat 2 ausgetauscht werden kann. Mittels des Greiferarms 44 kann die fertig beschichtete Compact Disk einer weiteren nicht dargestellten Transporteinrichtung zugeführt werden. Gleichzeitig wird eine neue zu bearbeitende Compact Disk 2 in die Einschleuskammer 30 eingelegt. Durch Absenken des Deckels 33' preßt sich ein in der Zeichnung nicht dargestellter O-Ring gegen die Oberfläche eines Gehäuses 37 der Einschleuskammer 30 an, die dadurch vakuumdicht verschlossen wird. Der in der Einschleuskammer 30 herrschende Atmosphärendruck wird durch Schließen des Ventils 32 und dann durch anschließendes Öffnen eines Ventils 26, das über die Leitung 46 mit der Einschleuskammer 30 verbunden ist, evakuiert. Eine Vakuumpumpe 48 pumpt die in der Einschleuskammer 30 vorhandene Luft ab und erzeugt den erforderlichen Vakuumdruck.

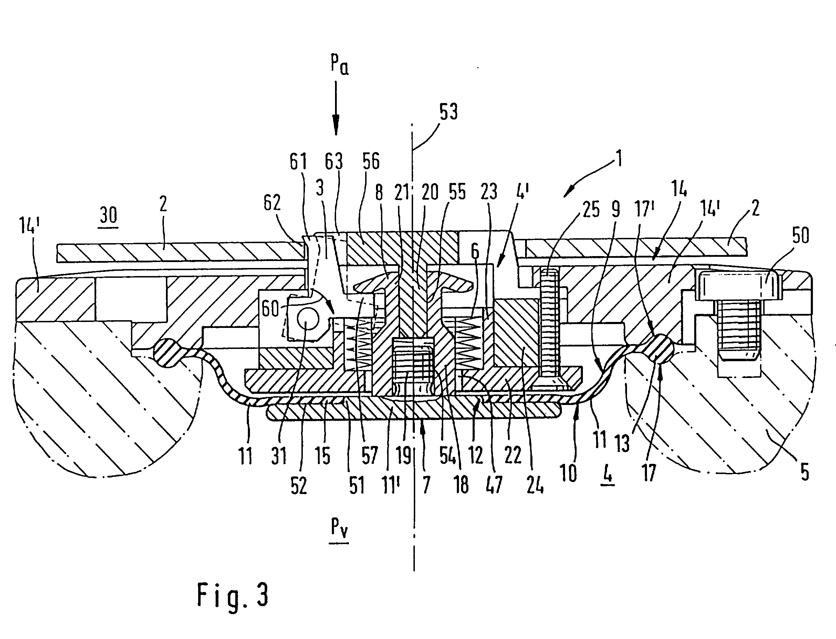

Bei diesem Vorgang öffnen sich nachstehend näher erläuterte Greifer 3, die in Figur 3 im Detail wiedergegeben sind. Die Greifer 3 erfassen das Substrat 2 bzw. die Compact Disk. Dies tritt sofort ein, wenn der Druck in der Einschleuskammer 30 in etwa dem Druck in einer Vakuumkammer 4 (Figur 3) entspricht, d. h. wenn Druckausgleich erfolgt ist. Ist die Einschleuskammer 30 soweit evakuiert, daß der erforderliche Meßdruck, der mittels einer Meßzelle 34 ermittelt wird, hergestellt ist, so kann die Vorrichtung 1 nach unten abgesenkt und das auf einem Drehteller 49 (Figur 1) abgelegte Substrat 2 mittels des Drehtellers 49 der Prozeßstation 43 schrittweise zugeführt werden. Hierzu dreht sich der Drehteller 49 jeweils um 120° weiter.

Anschließend wird das Substrataufnahmeteil 14 angehoben, wobei sich ein nicht dargestellter O-Ring gegen die Unterseite des Deckels der Kathode 41 legt.

Nach diesem Arbeitsschritt kann die Einschleuskammer 30 wieder über das Ventil 32 geflutet werden. Bei diesem Flutungsvorgang entsteht eine Druckdifferenz Pd, die sich aus dem Atmosphärendruck Pₐ in der Einschleuskammer 30 und dem Vakuumdruck Pᵥ in der Vakuumkammer 4 (siehe Figur 3) ergibt (P_{d} = Pₐ - Pᵥ).

Durch diese Druckdifferenz werden die Greifer 3 wieder verschwenkt und das Substrat 2 freigegeben. Bei diesem Arbeitsvorgang wird gleichzeitig auch der Greifer des Substrataufnahmeteils bzw. des Tellers 33 aktiviert, so daß das Substrat von dem Teller 33 übernommen werden kann. Dieser Arbeitsprozeß wiederholt sich fortlaufend.

Die Vakuumkammer 4 wird über die Leitungen 38, 39 und die Vorpumpe 29 evakuiert.

In Figur 3 ist die Vorrichtung 1 zum Greifen und Halten der Substrate 2 im Detail wiedergegeben, wobei die Vorrichtung 1 lediglich schematisch angedeutet ist.

Die Vorrichtung 1 besteht aus einem Flansch 14', der über Schraubenbolzen 50 mit einem Substrathalter 5 lösbar verbunden ist. Zwischen dem Flansch 14' und dem Substrathalter 5 ist eine halbkreisförmige Nut 17 vorgesehen, in der ein wulstartiger Rand 13 einer Membrane 7 eingeklemmt ist. Die Membrane 7 befindet sich in der Vakuumkammer 4 und besteht aus einem flexiblen Teil 11 und einem an diesen angeschlossenen, nicht flexiblen Teil 11', der als kreisrunder Teller ausgebildet ist und der in einer Öffnung 12 der Membrane 7 eingelassen ist. Hierzu weist der Teller 11' einen zylinderförmigen Ansatz 51 auf, so daß ein Randteil 52 gebildet wird, an das der flexible Teil 11 der Membrane 7 befestigt bzw. anvulkanisiert sein kann. Die Membrane 7 dichtet den oberen Teil einer Vakuumkammer 4' (Figur 3) bzw. 4'' (Figur 1) gegenüber der einem permanenten Vakuumdruck Pᵥ ausgesetzten Vakuumkammer 4 ab. Der flexible Teil 11 der Membrane 7 ist mit seinem äußeren Rand 13 an einen Flansch 14' und mit seinem innenliegenden Rand 15 an den zylinderförmigen Ansatz 51 angeschlossen. Der äußere Rand 13 ist in einer Nut 17, 17' des Flansches 14' und dem Substrathalter 5 eingeklemmt.

Die Vakuumkammer 4', 4'' wird dann einem Atmosphärendruck Pₐ ausgesetzt, wenn, wie bereits erwähnt, das Ventil 32 geöffnet und die Einschleuskammer 30 geflutet wird.

Der Teller 11' der Membrane 7 weist einen Zapfen 19 auf, der koaxial zu einer Mittelachse 53 der Vorrichtung 1 ausgerichtet ist. Der Zapfen 19 ist fest bzw. einteilig mit dem Teller 11' verbunden. Der Zapfen 19 weist Außengewinde 54 auf und kann daher mit einem zylinderförmigen Teil 18 verbunden bzw. lösbar verschraubt werden.

Das zylinderförmige Teil 18 ist hierzu ebenfalls koaxial zum Flansch 14' ausgerichtet und weist in seinem oberen Bereich eine zylinderförmige Bohrung 55 auf, in die sich ein Zapfen 20 erstreckt. Der Zapfen 20 ist mit einem zylinderförmigen Ansatz 56 verbunden, der über Verbindungselemente 25 mit dem Flansch 14' verbunden ist. Auf den zylinderförmigen Ansatz 56 kann die Compact Disk bzw. das Substrat 2 aufgeschoben und mittels der drei oder mehreren Greifer 3 gehalten werden. Der zylinderförmige Teil 18 ist bei auftretender Druckdifferenz P_{d} mit Bezug auf die Mittelachse 53 auf dem Zapfen 20 vertikal verstellbar.

Am oberen Ende des zylinderförmigen Teils 18 ist ein Stellteil bzw. ein glockenförmig ausgebildeter Flansch 8 vorgesehen. Das Stellteil 8 ist an einem oberen Ende 21 des zylinderförmigen Teils 18 fest angeschlossen.

Wie aus Figur 3 3 hervorgeht, liegt der Flansch 8 8 mit seinem äußeren Ende gegen einen Hebelarm 57 je eines Greifers 3 an. Der Greifer 3 ist auf einem mit Bezug auf Figur 3 horizontal verlaufenden Bolzen 31 zwischen der in ausgezogenen Linien dargestellten Stellung (Haltestellung) und einer in gestrichelten Linien dargestellten Stellung (Freigabestellung) verschwenkbar gelagert.

Das untere Ende des zylinderförmigen Teils 18 bewegt sich mit seinem einen Ende bzw. seinem Teller 11' in Richtung der Unterseite eines feststehenden Flansches 22, während er mit seinem anderen Ende bzw. seinem Stellteil 8 gegen den Greifer 3 bzw. dessen Hebelarm 57 anliegt. In diesem Betriebszustand befindet sich der Greifer 3 in der in Figur 3 dargestellten Halteposition, in der das Substrat 2 von den Greifern 3 getragen wird. Der Flansch 22 ist über die Verbindungselemente 25 mit einem Tragteil 24 und dem Flansch 14' fest verbunden. Auf dem Flansch 22 befindet sich eine zylinderförmige Verlängerung 23, in der eine Feder bzw. Tellerfeder 6 aufgenommen ist. Die Feder 6 stützt sich mit ihrem unteren Ende gegen den Flansch 22 und mit ihrem oberen Ende gegen den Hebelarm 57 des Greifers 3 ab und drückt diesen bei Druckausgleich Pₐ = Pᵥ in seine Halteposition gemäß Figur 3. Hierzu umgibt die zylinderförmige Feder 6 das zylinderförmige Teil 18. Das mit dem Flansch 22 verbundene Tragteil 24 dient zur verschwenkbaren Aufnahme der Greifer 3. Der Flansch 22 weist eine Bohrung 47 auf, durch die sich das zylinderförmige Teil 18 erstreckt.

Der feststehende Flansch 22 und der Tragteil 24 sind über die gleichen Verbindungselemente 25 mit dem Flansch 14' der Vorrichtung 1 lösbar verbunden. Die oberhalb der Membrane 7 vorgesehene Vakuumkammer 4', 4'' bzw. die Einschleuskammer 30 kann, wie bereits mit Bezug auf Figur 1 erläutert, über das Ventil 32 geflutet und über die Pumpe 48 evakuiert werden. Die unterhalb der Membrane 7 vorgesehene Vakuumkammer 4 wird bei Arbeitseinsatz nicht geflutet und über eine Vakuumpumpen 27 bzw. die Vorpumpe evakuiert bzw. auf einem bestimmten Druckniveau gehalten.

Wird für den Arbeitsprozeß und zum Transport des Substrats 2 die Einschleuskammer 30 bzw. Vakuumkammer 4' über das Ventil 32 gemäß Figur 1 geflutet, so tritt oberhalb der Membrane 7 ein sofortiger Druckanstieg Pₐ ein, so daß die Membrane 7 aufgrund der Druckdifferenz (P_{d} = Pₐ - Pᵥ) weiter in die Vakuumkammer 4 gemäß Figur 3 nach unten bewegt wird und mittels des Stellteils 8 der Greifer 3 aus der in ausgezogenen Linien dargestellten Stellung in die in gestrichelten Linien dargestellte Stellung (Freigabestellung für Substrat) im Uhrzeigerdrehsinn gemäß Pfeil 60 verschwenkt wird. Dabei gelangt der obere Teil 61 des Greifers 3 aus dem Bereich eines Randes 62 einer Bohrung 63 des Substrats 2 und gibt auf diese Weise das Substrat bzw. die Compact Disk zum Transport frei.

Mit der erfindungsgemäßen Anlage wird also immer dann ein zwangsweises Verstellen des Greifers 3 in eine Freigabestellung gemäß Figur 3 bewirkt, wenn die Einschleuskammer 30 geflutet wird.

Wird nach der Substratübergabe die Einschleuskammer 30 bzw. Vakuumkammer 4' über die Pumpe 48 wieder evakuiert, so erfolgt zwischen der Einschleuskammer 30 und der Vakuumkammer 4 ein Druckausgleich, so daß dadurch die Feder 6 den Hebelarm 57 und dadurch auch das Stellteil 8 nach oben bewegt, da nun auf einer Seite 9 und einer anderen Seite 10 der Membrane 7 7 die gleichen Druckzustände herrschen. Hierdurch arbeitet das Greifersystem völlig störungsfrei und kann in kürzester Zeit, also in Millisekunden, ansprechen.

Durch die sehr kurze Ansprechzeit der Greifer 3 und das zwangsweise Verstellen beim Fluten der Einschleuskammer 30 wird die Standsicherheit bzw. der Arbeitsprozeß störungsfreier und die Taktzeit zusätzlich verringert. Außerdem kann durch diese Anordnung die Vorrichtung 1 zum Greifen der Substrate wesentlich einfacher gestaltet und somit kostengünstiger hergestellt werden, da man insgesamt mit weniger Bauteilen auskommen kann. Die bisherige externe Ansteuerung der Membrane zum Verstellen der Greifer 3 war aufgrund der fehlenden Einzelteile störanfälliger und nicht so funktionssicher, wenn z. B. die externe Versorgungspumpe zur Erzeugung eines Überdrucks an der Membrane 7 ausfiel.

Die Oberseite der Membrane ist über die Bohrung 47 mit der Vakuumkammer 4' verbunden.

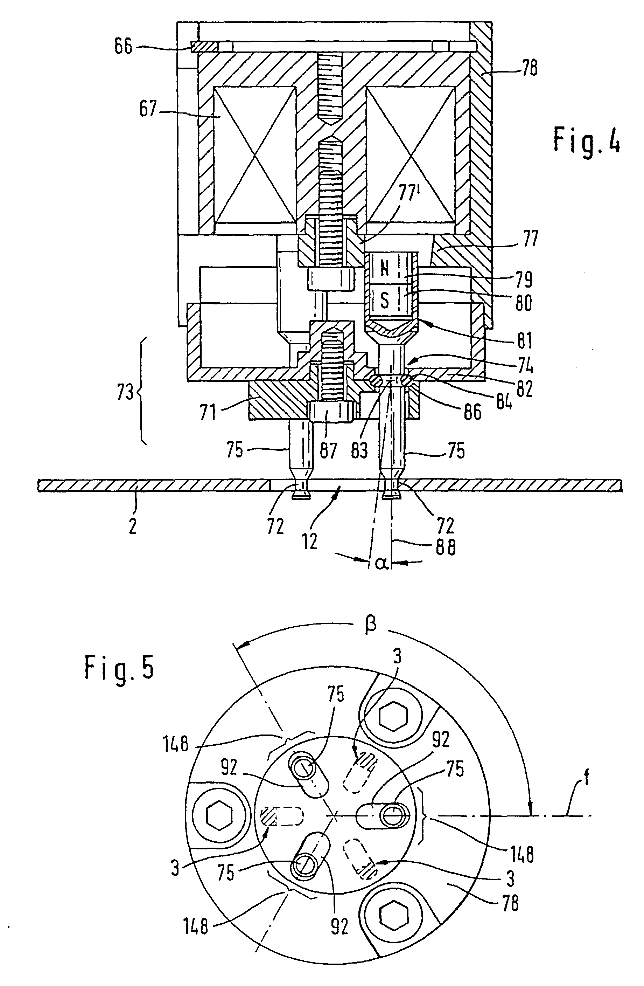

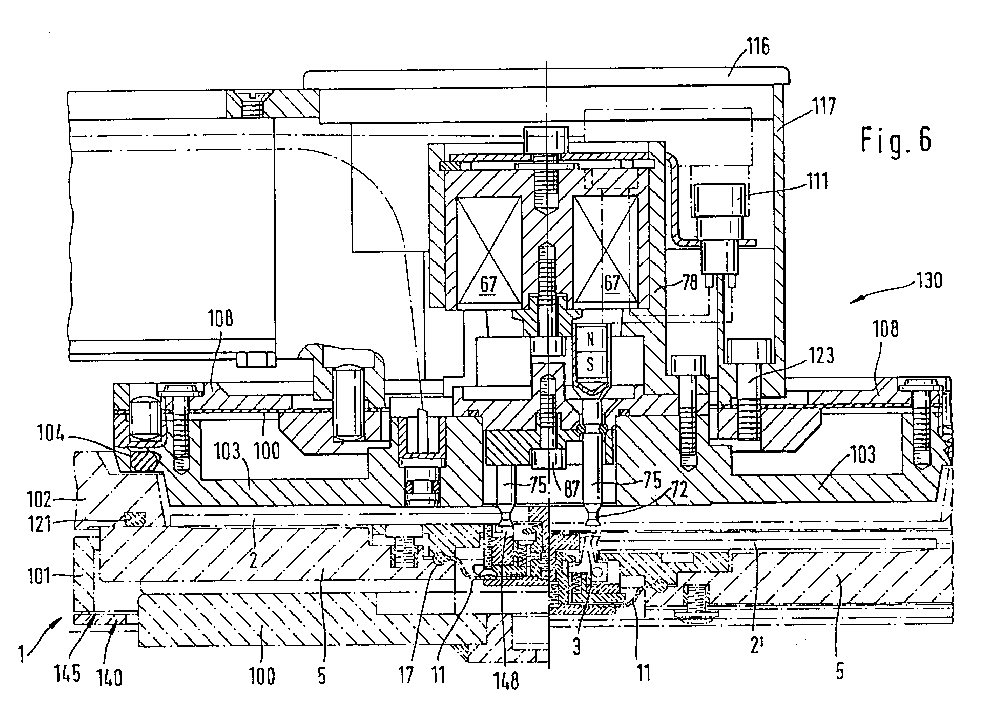

In Figur 4, 6 ist eine erste Vorrichtung 130 zum Greifen und Halten der Substrate 2 gezeigt, zu der die um eine mit Bezug auf Figur 4 horizontal verlaufende Achse 83 schwenkbaren Greifer 75 gehören. Die Greifer 75 sind hierzu in einem zylinderförmigen Gehäuse 78 angeordnet, das zur Aufnahme eines Elektromagneten 67 dient, der über einen Stecker 111 mit einer in der Zeichnung nicht dargestellten Stromversorgungseinrichtung verbindbar ist (vgl. Figur 6). Der Elektromagnet 67 ist mittels eines Sicherungsrings 66 gesichert, der am oberen Ende des Gehäuse 78 vorgesehen ist. Am unteren Ende weist das Gehäuse einen Boden 82 mit mindestens drei Öffnungen 74 auf, durch die sich die Greifer 75 erstrecken. Die Greifer 75 sind über elastisch ausgebildete Lager 84 um die mit Bezug auf Figur 4 horizontal verlaufende Achse 83 zwischen zwei Anschlägen 77, 77', die fest mit dem Gehäuse 78 verbunden sind, verschwenkbar.

Wie aus Figur 4 hervorgeht, weist das obere Ende eines jeden Greifers 75 ein zylinderförmiges Gehäuse 81 zur Aufnahme eines oberen und eines unteren Magneten 79 und 80 auf. Die Wand des zylinderförmigen Gehäuses 81 ist dünnwandig ausgebildet und kann eine Wandstärke zwischen 0,2 mm und 1,0 mm bzw. zwischen 0,3 mm und 0,7 mm bzw. zwischen 0,4 mm und 0,6 mm, insbesondere 0,5 mm, aufweisen, um am Magneten 67 bei Anlage eine gute Haltekraft zu gewährleisten.

Im Ausführungsbeispiel ist der obere Magnet mit N und der untere Magnet mit S bezeichnet. Durch Einschalten des Ringmagneten 67 läßt sich der Greifer 75 zwischen den beiden Anschlägen 77 und 77' verstellen und legt dabei den Weg, der durch den Winkel a gekennzeichnet ist, zurück. In der Halteposition verläuft die Längsmittelachse des Greifers 75 parallel zur Längsmittelachse des Gehäuses 78. In dieser Stellung wird das Substrat über am unteren Ende des Greifers vorgesehene nutenförmige Vertiefungen 72 gesichert.

Wie aus Figur 5 hervorgeht, erstrecken sich die unteren Enden der Greifer durch Langlochöffnungen 92, die eine exakte Führung der Greifer gewährleisten. Wird mit Bezug auf Figur 4 durch entsprechende Polungen des Ringmagneten 67 der Greifer 75 verschwenkt, so bewegt er sich von dem linken Anschlag 77' zu dem rechten Anschlag 77 und nimmt dabei eine geneigt verlaufende Haltung ein, so daß er sich mit seiner Vertiefung 72 aus dem Randbereich der Bohrung bzw. Öffnung 12 des Substrats 2 wegbewegt und dieses für die Übergabe der zweiten Vorrichtung 1 freigibt.

Nach dem Ausführungsbeispiel gemäß Figur 4 4 kann das elastisch ausgebildete Lager 84 in einer entsprechenden im Boden 82 und einem sich daran anschließenden Aufnahmeteil 71 vorgesehenen Ringnut 86 aufgenommen sein. Das Aufnahmeteil 71 ist hierzu über Schrauben 87 mit dem Boden 82 des Gehäuses 78 lösbar verbunden.

Wie aus Figur 5 hervorgeht, sind die einzelnen Greifer 75 der ersten Vorrichtung 130 jeweils um 120° versetzt zueinander ausgerichtet und bilden auf diese Weise Zwischenräume 148, die ausreichend Platz für die Greifer 3 der zweiten Vorrichtung 1 zum Greifen von Substraten bieten. Durch die vorteilhaft angeordneten Zwischenräume 148 können die beiden Vorrichtungen 1 und 130 sehr dicht aneinander herangeführt werden und somit eine exakte Übergabe der Substrate zwischen den beiden Vorrichtungen sichergestellt werden, wobei bei der Übergabe die oberen Greifer 75 kurzfristig in die Zwischenräume 148 der jeweils zwei nebeneinander liegenden, unteren Greifer 3 eingreifen, wenn die beiden Vorrichtungen zusammengefahren werden.

Wie aus Figur 5 ferner hervorgeht, beträgt der Winkel β zwischen zwei nebeneinander liegenden Greifern 75 120°. Die Greifer 75 sowie die Greifer 3 sind jeweils sternförmig angeordnet, und der Winkel zwischen dem Greifer 75 und dem Greifer 3 beträgt 60°.

Die in Figur 4 wiedergegebene Vorrichtung zum Greifen und Halten der Substrate 2 ist in Figur 6 in der Gesamtvorrichtung veranschaulicht, wobei die Vorrichtung 130 als obere Vorrichtung dargestellt ist. Ein aus den Greifern 75 gebildetes Substrataufnahmeteil 73 mit den Elektromagneten 67 ist, wie aus Figur 6 hervorgeht, in einem Greiferträger 117 aufgenommen, der über Schraubenbolzen 123 mit einem Anschlagdeckel 108 lösbar verbunden ist. An den Anschlagdeckel 108 ist mittels der Schraubenbolzen 123 ein Schleusendeckel 103 lösbar angeschlossen. Das Substrataufnahmeteil 73 mit dem Schleusendeckel 103 bildet die obere Vorrichtung 130 zum Aufnehmen und Greifen der Substrate 2. Wird das Substrat 2 über die gesamte Vorrichtung 130 an die in Figur 3 3 bereits ausführlich beschriebene zweite Vorrichtung 1 herangefahren, so legt sich der Schleusendeckel 103 mittels einer Dichtung 104 dichtend gegen die Stirnfläche eines Rezipientendeckels 102, 41 an. Dabei bildet sich zwischen der Oberfläche des Substrathalters 5 und der Unterseite des Schleusendeckels 103 die Einschleuskammer 30, die über die Leitung 46 entweder geflutet oder evakuiert werden kann, wie das aus der schematischen Darstellung gemäß Figur 1 hervorgeht.

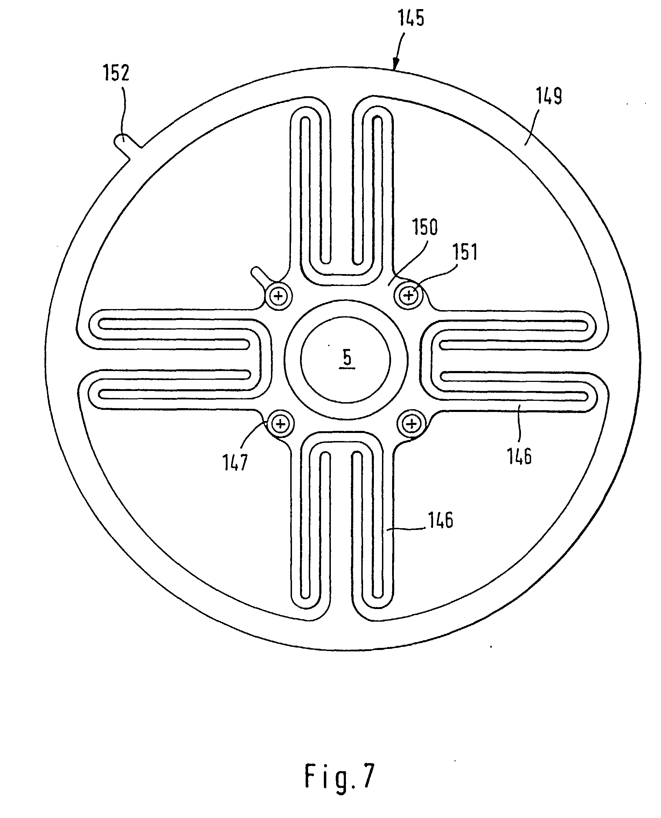

In Figur 7 ist zwischen einem Drehteller 101 gemäß Figur 6, der zweiten Vorrichtung 1 1 und dem Substrathalter 5 ein einen Hub zulassendes, federelastisches Verbindungselement bzw. Membranteil 145 vorgesehen, das als kreisförmige Scheibe mit einem äußeren Rand 149 ausgestattet ist, der über meanderförmig ausgebildete Stege 146 mit einem zentrisch angeordneten Flansch 150 verbunden ist. Der Flansch 150 ist über Schraubenbolzen 151 mit dem Substrathalter 5 verbunden, während der äußere Ring 149 an den Drehteller 101 angeschlossen ist. Ein Zapfen 152 sichert die richtige Einbauweise des Substrathalters 5 in den Drehteller 101 und arretiert den Substrathalter 5 gegenüber dem Drehteller 101.

Durch die Membrane 145 wird eine Drehsicherung zwischen diesen beiden Teilen geschaffen, die sicherstellt, daß beim Anheben des Substrathalters 5 die Greifer 75 in die Zwischenräume der Greifer 3 eingreifen können.

Die Übergabe des Substrats 2 von der ersten Vorrichtung 130 zu der zweiten Vorrichtung 1 gemäß Figur 1 (wie bereits beschrieben) und Figur 6 geschieht in folgenden Arbeitsschritten:

Zuerst wird das Ventil 26 geöffnet und die Einschleuskammer 30 über die Pumpe 48 evakuiert. Hierdurch entsteht Druckgleichheit auf der Ober- und Unterseite des Substrathalters 5. In diesem Stadium nimmt die Membrane 7 die Stellung gemäß Figur 3 ein, wobei die Feder 6 den Hebel bzw. den Greifer 3 nach außen schwenkt und dabei das ihm zugeführte Substrat 2 hält. Hierzu wird zum gleichen Zeitpunkt der Magnet 67 angesteuert und verschwenkt die Greifer 75 in eine geneigt verlaufende Position gemäß Figur 4 (siehe Winkel α), wobei die oberen Enden der Greifer gegen die entsprechenden Anschläge 77 zur Anlage kommen und dabei das Substrat 2 freigeben.

Nun kann ein Stützteller 100 mit dem Substrathalter 5 in die in Figur 6 dargestellte rechte, untere Stellung verschoben werden, wobei gleichzeitig der Teller bzw. Substrathalter 5 5 über die Membrane bzw. das Verbindungselement 145 nach unten mitgenommen wird, bis der Substrathalter 5 gegen einen Anschlag 140 des Drehtellers 101 anliegt. Nun kann der Substrathalter 5 eine Schwenkbewegung ausführen, ohne daß dabei eine Relativbewegung zwischen Substrathalter 5 und Drehteller 101 auftritt.

Nach diesem Arbeitsablauf nimmt der nächste, in der Zeichnung nicht dargestellte Substrathalter die zuvor beschriebene Position ein, wozu der Stützteller 100 mit dem Substrathalter 5 wieder nach oben gefahren wird, bis er gegen eine Dichtung 121 anliegt und die Einschleuskammer 30 verschlossen wird. Bei diesem Stellvorgang bleibt das Substrat noch so lange in den Greifern 3, bis das Ventil 32 geöffnet und die Einschleuskammer geflutet wird, so daß dann in der Einschleuskammer Atmosphärendruck eintritt. Hierdurch entsteht der bereits erwähnte Differenzdruck zwischen der Ober- und Unterseite des Substrathalters 5, so daß sich die Membrane 7 weiter in den Vakuumraum 4 bewegt und dabei die Greifer 3 aus der in ausgezogenen Linien dargestellten Stellung in die in gestrichelten Linien dargestellte Stellung gemäß Figur 3 verschwenkt. Hierdurch wird das Substrat bzw. die Compact Disk 2 freigegeben. Nun können zum gleichen Zeitpunkt auch die Greifer 75 der oberen Vorrichtung 130 über die Polschuhe angesteuert werden, so daß sie aus ihrer geneigt verlaufenden Lage in ihre vertikal verlaufende Lage gemäß Figur 4 verschwenkt werden und dabei das Substrat 2 erfassen. Jetzt kann das obere Substrat abgehoben werden und durch Schwenken des Greiferträgers 117 das nächste Substrat 2 in die beschriebene Position gebracht werden.

### Bezugszeichenliste

1 Vorrichtung zum Greifen von Substraten (Disk-Receiver)
2 Substrat, CD
3 Greifer
4 Vakuumkammer
4' Vakuumkammer, dem Atmosphärendruck aussetzbar
4" Vakuumkammer
5 Substrathalter
6 Feder, Tellerfeder
7 Membrane
8 Stellteil, Flansch
9 erste Seite
10 zweite Seite
11 flexibles Teil
11' nicht flexibles Teil bzw. Metallteil, Teller
12 Öffnung
13 Rand
14 Substrataufnahmeteil (Teller)
14' Flansch
15 Rand
17 Nut
17' Nut
18 zylinderförmiges Teil
19 Zapfen
20 Zapfen
21 Ende, Stellteil
22 feststehender Flansch
23 Verlängerung
24 Tragteil
25 Verbindungselemente
26 Einrichtung, Steuerventil (offen, wenn geflutet wird)
27 Vakuumpumpe (Turbo-Molekularpumpe)
28 Filter
29 Vorpumpe
30 Einschleuskammer = Vakuumkammer
31 Bolzen
32 Ventil
33 Teller zur Aufnahme von CD
33' Teller, Deckel
34 Meßzelle
37 Gehäuse mit Vakuumkammer
38 Vakuumleitung
39 Vakuumleitung
40 Sputteranlage
41 Kathode, Rezipientendeckel
43 Prozeßstation
44 Greiferarm
45 Leitung
46 Leitung
47 Bohrung
47' Leitung
48 Vakuumpumpe
49 Drehteller
50 Schraubenbolzen
51 zylinderförmiger Ansatz
52 Randteil
53 Mittelachse
54 Außengewinde
55 Bohrung
56 zylindrischer Ansatz
57 Hebelarm
60 Pfeil
61 oberer Teil des Greifers
62 Rand
63 Bohrung, Substrat 2
66 Sicherungsring
67 Elektromagnet, Ringmagnet
71 Aufnahmeteil
72 Vertiefung
73 Substrataufnahmeteil
74 Öffnung
75 Greifer
77 Anschlag
77' Anschlag
78 Gehäuse
79 Magnet
80 Magnet
81 Gehäuse
82 Boden
83 Achse
84 Lager
86 Ringnut
87 Schraube
88 Längsachse
92 Langlochöffnungen
93 Langlochöffnung
100 Stützteller
101 Drehteller
102 Kathode, Rezipientendeckel
103 Schleusendeckel
104 Dichtung
108 Anschlagdeckel
111 Stecker
116 Deckel
117 Greiferträger
121 Dichtung
123 Schraubenbolzen
130 mechanische und/oder elektromechanische Stelleinrichtung
140 Anschlag
145 Verbindungselement, Membranfeder
146 Steg
147 Verbindungselement
148 Zwischenräume
149 Rand, Ring
150 Flansch
151 Schraubenbolzen
152 Zapfen

## Patentansprüche

1. Vorrichtung zum Transport von Substraten zwischen einer ersten (130) und mindestens einer zweiten (1) Vorrichtung zum Greifen und Halten von Substraten (2) mit einem oder mehreren in einer Vakuumkammer (4, 4', 4'') angeordneten Substrathaltern (5), **dadurch gekennzeichnet**, daß die erste Vorrichtung zum Greifen und Halten von Substraten (2) mit einem oder mehreren verstellbar angeordneten Greifern (75) ausgerüstet ist, die mittels einer mechanischen und/oder elektromechanischen bzw. magnetisch arbeitenden Stelleinrichtung (130) in eine das Substrat haltende bzw. freigebende Stellung verstellbar sind, wobei die zweite koaxial zur ersten ausgerichtete Vorrichtung (1) zum Greifen und Halten von Substraten (2) ebenfalls mit einem oder mehreren verstellbar angeordneten Greifern (75) ausgerüstet ist.

2. Vorrichtung nach Anspruch 1, **dadurch gekennzeichnet**, daß die Greifer (75) gegen die Wirkung eines Stelldrucks bzw. gegen die Wirkung einer Feder (6) in eine erste Stellung und über die Wirkung einer einem pneumatischen Druck Pₐ und/oder Vakuumdruck Pᵥ aussetzbaren Membrane (7) und eines mit dieser zusammenwirkenden Stellteils (8) in eine zweite Stellung verstellbar sind, wobei in der einen Stellung das Substrat (2) gehalten und in der zweiten Stellung das Substrat (2) für den Weitertransport gelöst wird, wobei in der Stellung der beiden Vorrichtungen (1, 130) zur Übergabe des Substrats (2) die beiden Substrataufnahmeteile (14, 73) koaxial zueinander ausrichtbar und fixierbar sind, wobei nach koaxialer Ausrichtung und bei vakuumdichter Anlage der beiden Vorrichtungen (1, 130) der Druck in der Einschleuskammer (30) abgesenkt und das über die erste Vorrichtung (130) an die zweite Vorrichtung (1) abgegebene Substrat (2) mittels der zweiten Vorrichtung (1) über den nun freiwerdenden Federdruck gehalten wird.

3. Vorrichtung nach Anspruch 1 oder 2, **dadurch gekennzeichnet**, daß zwischen einem Drehteller (101) der zweiten Vorrichtung (1) und einem Substrathalter (5) ein einen Hub zulassendes, federelastisches Verbindungselement (145) vorgesehen ist.

4. Vorrichtung nach Anspruch 1, **dadurch gekennzeichnet,** daß das Verbindungselement (145) aus einem mittleren Flansch besteht, der über Verbindungselemente (147) mit dem Substrathalter (5) und über elastische Stege (146) mit dem Drehteller (101) verbunden ist.

5. Vorrichtung nach einem oder mehreren der vorhergehenden Ansprüche, **dadurch gekennzeichnet**, daß die der ersten Vorrichtung (130) zugeordneten Greifer (75) mittels eines Stellelements bzw. Magnets (67) und/oder Federelementen um eine Achse (83) zwischen einer das Substrat (2) haltenden und einer das Substrat (2) freigebenden Stellung verschwenkbar sind.

6. Vorrichtung nach Anspruch 1, **dadurch gekennzeichnet**, daß die der ersten Vorrichtung (130) zugeordneten Greifer (75) um eine Achse (83) schwenkbar sind, die die Längsachse (88) des Greifers (75) oder des Gehäuses (78) in einem annähernd rechten Winkel schneidet.

7. Vorrichtung nach einem oder mehreren der vorhergehenden Ansprüche, **dadurch gekennzeichnet**, daß die der ersten Vorrichtung (1) zugeordneten Greifer (3) bereits beim Fluten der Einschleuskammer (30) ansprechen und die Greifer (3) der zweiten Vorrichtung (1) über den E-Magneten in eine Aufnahmestellung verstellt sind.

8. Vorrichtung nach einem oder mehreren der vorhergehenden Ansprüche, **dadurch gekennzeichnet**, daß zwei oder mehrere mit Abstand zueinander angeordnete Greifer (75) der ersten Vorrichtung (130) bei der Substratübergabe in die Zwischenräume (148) der ebenfalls mit Abstand zueinander angeordneten Greifer (3) der zweiten Vorrichtung (1) eingreifen.

9. Vorrichtung nach einem oder mehreren der vorhergehenden Ansprüche, **dadurch gekennzeichnet**, daß die Greifer (3 oder 75) im Bereich ihres einen Endes in Langlochöffnungen (93) geführt sind und im Bereich ihres anderen Endes in einem Zylindergehäuse (81) und mindestens einen Dauermagneten (80) aufweisen, der mit einem Ringmagneten (67) zusammenwirkt.

10. Vorrichtung nach Anspruch 9, **dadurch gekennzeichnet**, daß das Zylindergehäuse (81) dünnwandig ausgebildet ist und eine Wandstärke zwischen 0,2 mm und 1,0 mm bzw. 0,3 mm und 0,7 mm bzw. 0,4 mm und 0,6 mm aufweist.

11. Vorrichtung nach einem oder mehreren der vorhergehenden Ansprüche, **dadurch gekennzeichnet**, daß die Greifer (75) in einem elastischen Ringlager (84) schwenkbar aufgenommen und im Bereich ihres oberen Endes zwischen magnetisierbaren Anschlägen (77, 77') verstellbar sind.

12. Vorrichtung nach Anspruch 1, **dadurch gekennzeichnet**, daß die einem in etwa konstanten Vakuumdruck Pᵥ auf einer Seite (10) ausgesetzte Membrane (7) über einen Differenzdruck P_{d} = Pₐ - Pᵥ steuerbar ist, der dann auftritt, wenn die Kammer (30, 4', 4'') zur Aufnahme des Substrats (2) geflutet wird.

13. Vorrichtung nach Anspruch 1 oder 12, **dadurch gekennzeichnet**, daß die Membrane (7) über den Atmosphären- und/oder Vakuumdruck bzw. den Differenzdruck P_{d}, der sich aus dem Atmosphärendruck Pₐ in der Einschleuskammer (30) abzüglich des Vakuumdrucks Pᵥ in der Vakuumkammer (4) ergibt, steuerbar ist.

14. Vorrichtung nach Anspruch 1, **dadurch gekennzeichnet,** daß die in der Vakuumkammer (4) angeordnete Membrane (7) aus einem flexiblen (11) und einem nicht flexiblen Teil (11') bzw. einem Metallteil bzw. Teller gebildet ist.

15. Vorrichtung nach einem oder mehreren der vorhergehenden Ansprüche, **dadurch gekennzeichnet**, daß der nicht flexible Teil (11') mit dem flexiblen Teil (11) der Membrane (7) fest verbunden ist.

16. Vorrichtung nach Anspruch 1, **dadurch gekennzeichnet,** daß der nicht flexible Teil (11') als kreisrunder Teller ausgebildet ist, der eine Öffnung (12) der Membrane (7) abdeckt.

17. Vorrichtung nach einem oder mehreren der vorhergehenden Ansprüche, **dadurch gekennzeichnet**, daß der flexible Teil (11) der Membrane (7) mit seinem äußeren Rand (13) an einen Flansch (14) der Vorrichtung (1) und mit dem innenliegenden Rand (15) an den Rand (51) der im Teller (11') vorgesehenen Öffnung (12) fest angeschlossen ist.

18. Vorrichtung nach einem oder mehreren der vorhergehenden Ansprüche, **dadurch gekennzeichnet**, daß die Membrane (7) und der Teller (11') die einem ständigen Vakuumdruck Pᵥ ausgesetzte Kammer (4) gegenüber der einem Atmosphärendruck Pₐ aussetzbaren Kammer (4') bzw. Einschleuskammer (30) abdichten.

19. Vorrichtung nach einem oder mehreren der vorhergehenden Ansprüche, **dadurch gekennzeichnet,** daß der äußere Rand (13) der Membrane (7) in mindestens einer zwischen dem Flansch (14') und dem Außenteil des Substrathalters (5) vorgesehenen Nut (17, 17') einklemmbar und sicherbar ist.

20. Vorrichtung nach einem oder mehreren der vorhergehenden Ansprüche, **dadurch gekennzeichnet**, daß der Teller (11) über einen koaxialen Zapfen (19) mit einem zylinderförmigen Teil (18) verbunden bzw. verschraubt ist, das auf einem mit einem ebenfalls koaxial angeordneten Flansch (14) verbundenen Zapfen (20) geführt ist.

21. Vorrichtung nach einem oder mehreren der vorhergehenden Ansprüche, **dadurch gekennzeichnet**, daß das zylinderförmige Teil (18) mit dem Stellteil (3) fest verbunden ist.

22. Vorrichtung nach einem oder mehreren der vorhergehenden Ansprüche, **dadurch gekennzeichnet**, daß das Stellteil (8) im Bereich seines einen Endes (21) gegen einen oder mehrere Greifer (3) anliegt.

23. Vorrichtung nach einem oder mehreren der vorhergehenden Ansprüche, **dadurch gekennzeichnet**, daß das zylinderförmige Teil (18) mit seinem einen oder zweiten Ende bzw. seinem Teller (11') gegen einen feststehenden Flansch (22) und mit seinem ersten oder anderen Ende bzw. Stellteil (8) gegen den Greifer (3) bzw. Hebelarm (57) des Greifers (3) anlegbar ist.

24. Vorrichtung nach einem oder mehreren der vorhergehenden Ansprüche, **dadurch gekennzeichnet**, daß sich bei auftretendem Differenzdruck P_{d} die Membrane (7) weiter in den Vakuumraum (4) bewegt und dabei den oder die Greifer (3) vom Bohrungsrand (62) des Substrats (2) wegbewegt und dieses freigibt.

25. Vorrichtung nach einem oder mehreren der vorhergehenden Ansprüche, **dadurch gekennzeichnet**, daß der feststehende Flansch (22) mit dem Flansch (14) der Vorrichtung (1) mittel- oder unmittelbar fest verbunden ist.

26. Vorrichtung nach einem oder mehreren der vorhergehenden Ansprüche, **dadurch gekennzeichnet**, daß der feststehende Flansch (22) eine zylinderförmige Verlängerung (23) aufweist, in der die Feder (6) aufgenommen ist.

27. Vorrichtung nach einem oder mehreren der vorhergehenden Ansprüche, **dadurch gekennzeichnet**, daß zwischen dem Flansch (14) der Vorrichtung (1) und dem feststehenden Flansch (22) ein Tragteil (24) zur verschwenkbaren Aufnahme der Greifer (3) vorgesehen ist.

28. Vorrichtung nach einem oder mehreren der vorhergehenden Ansprüche, **dadurch gekennzeichnet**, daß der feststehende Flansch (22) und das Tragteil (24) über die gleichen Verbindungselemente (25) mit dem Flansch (14') der Vorrichtung (1) lösbar verbunden sind.

29. Vorrichtung nach einem oder mehreren der vorhergehenden Ansprüche, **dadurch gekennzeichnet**, daß die oberhalb der Membrane (7) liegende Kammer (4') bzw. die Einschleuskammer (30) über eine erste Vakuumpumpe (48) evakuiert und über eine weitere Einrichtung (32) geflutet und die unterhalb der Membrane (7) liegende Kammer (4) über eine zweite Vakuumpumpe (27) evakuiert wird, wobei die beiden Vakuumpumpen (48, 27) bzw. die zugehörigen Ventile derart steuerbar sind, daß der Differenzdruck P_{d} auf annähernd Null herabsenkbar ist.

30. Vorrichtung nach einem oder mehreren der vorhergehenden Ansprüche, **dadurch gekennzeichnet**, daß die obere Kammer (4'), die über eine Einrichtung bzw. über ein Steuerventil (32) geflutet wird, dadurch zwangsweise das sofortige Verstellen der Greifer (3) einleitet.

31. Vorrichtung nach einem oder mehreren der vorhergehenden Ansprüche, **dadurch gekennzeichnet**, daß der Greifer (3) über ein Zugteil verstellbar ist, das dann anspricht, wenn der Stelldruck dem Atmosphärendruck Pₐ entspricht.

32. Vorrichtung nach einem oder mehreren der vorhergehenden Ansprüche, **dadurch gekennzeichnet**, daß sich die Greifer (3) auf der Seite befinden, auf der sich ein Druck einstellt, der höher ist als der Vakuumdruck Pᵥ.

## Claims

1. An apparatus for transporting substrates between a first (130) and at least one second (1) device for gripping and holding substrates (2), comprising one or more substrate holders (5) disposed in a vacuum chamber (4, 4', 4''), **characterized in that** said first device for gripping and holding substrates (2) is equipped with one or more adjustably arranged grippers (75) which are adjustable by means of a mechanical and/or electromechanical or magnetically operating adjusting device (130) into a position in which the substrate is held or released, the second device (1) for gripping and holding substrates (2), which is coaxially oriented to the first, being also equipped with one or more adjustably arranged grippers (75).

2. The apparatus according to claim 1, **characterized in that** the grippers (75) are adjustable counter to the action of an adjusting pressure or counter to the action of a spring (6) into a first position and via the action of a diaphragm (7) that may be subjected to a pneumatic pressure Pₐ and/or vacuum pressure P, and an adjusting part (8) co-operating with said diaphragm into a second position, wherein in the one position said substrate (2) is held and in the second position said substrate (2) is released for further transport, wherein in the position of said two devices (1, 130) for transfer of said substrate (2), the two substrate receiving parts (14, 73) may be aligned and fixed coaxially to each other and wherein after coaxial alignment and with vacuum-tight contact of said two devices (1, 130) the pressure in the infeed chamber (30) is lowered and said substrate (2) dispensed to the second device (1) via the first device (130) is held by means of sai second device (1) via the spring pressure now released.

3. The apparatus according to claim 1 or 2, **characterized in that** a spring-elastic connecting element (145) that allows a reciprocation is provided between a turntable (101) of said second device (1) and a substrate holder (5).

4. The apparatus according to claim 1, **characterized in that** said connecting element (145) comprises a middle flange that is joined to said substrate holder (5) via connecting elements (147) and to said turntable (101) via elastic webs (146).

5. The apparatus according to one or more of the preceding claims, **characterized in that** the grippers (75) associated with said first device (130) are pivotable by means of a control element or magnet (67) and/or spring elements about an axis (83) between a position in which said substrate (2) is held and a position in which said substrate (2) is released.

6. The apparatus according to claim 1, **characterized in that** said grippers (75) associated with said first device (130) are pivotable about an axis (83) that intersects the longitudinal axis (88) of said gripper (75) or of said housing (78) at an approximately right angle.

7. The apparatus according to one or more of the preceding claims, **characterized in that** the grippers (3) associated with said first device (1) already respond when said infeed chamber (30) is flooded and the grippers (3) of said second device (1) are adjusted via said electromagnet into a receiving position.

8. The apparatus according to one or more of the preceding claims, **characterized in that** during substrate transfer two or more spaced-apart grippers (75) of said first device (130) engage the interstices (148) between the likewise spaced-apart grippers (3) of said second device (1) .

9. The apparatus according to one or more of the preceding claims, **characterized in that** said grippers (3 or 75) are guided in the region of their one end in oblong-slot openings (93) and are provided in the region of their other end in a cylinder housing (81) with at least one permanent magnet (80) that cooperates with a ring magnet (67).

10. The apparatus according to claim 9, **characterized in that** said cylinder housing (81) has thin walls with a wall thickness between 0.2 mm and 1.0 mm or 0.3 mm and 0.7 mm or 0.4 mm and 0.6 mm.

11. The apparatus according to one or more of the preceding claims, **characterized in that** said grippers (75) are pivotably received in an elastic ring bearing (84) and are adjustable in the region of their upper end between magnetizable stops (77, 77').

12. The apparatus according to claim 1, **characterized in that** said diaphragm (7) that is exposed to an approximately constant vacuums pressure Pᵥ on one side (10) is controllable via a differential pressure P_{d} = Pₐ -Pᵥ that occurs whenever said chamber (30, 4', 4'') for receiving said substrate (2) is flooded.

13. The apparatus according to claim 1 or 12, **characterized in that** said diaphragm (7) is controllable via the atmospheric and/or vacuum pressure or the differential pressure P_{d} that results from the atmospheric pressure Pₐ in said infeed chamber (30) minus the vacuum pressure Pᵥ in said vacuum chamber (4).

14. The apparatus according to claim 1, **characterized in that** said diaphragm (7) disposed in said vacuum chamber (4) is made of a flexible part (11) and an inflexible part (11') or a metal part or plate.

15. The apparatus according to one or more of the preceding claims, **characterized in that** said inflexible part (11') is firmly joined to said flexible part (11) of said diaphragm (7).

16. The apparatus according to claim 1, **characterized in that** said inflexible part (11') is a circular plate which covers one opening (12) of said diaphragm (7).

17. The apparatus according to one or more of the preceding claims, **characterized in that** said flexible part (11) of said diaphragm (7) is firmly connected by its outer edge (13) to a flange (14) of said device (1) and by its inner edge (15) to the edge (51) of said opening (12) provided in said plate (11').

18. The apparatus according to one or more of the preceding claims, **characterized in that** said diaphragm (7) and said plate (11') seal off said chamber (4) which is exposed to a constant vacuum pressure Pᵥ from said chamber (4') or said infeed chamber (30) which can be exposed to an atmospheric pressure Pₐ.

19. The apparatus according to one or more of the preceding claims, **characterized in that** said outer edge (13) of said diaphragm (7) may be clamped and secured in at least one groove (17, 17') provided between said flange (14') and the outer part of said substrate holder (5).

20. The apparatus according to one or more of the preceding claims, **characterized in that** said plate (11) is joined or screwed via a coaxial protrusion (19) to a cylindrical part (18) that is guided on a protrusion (20) joined to a likewise coaxially arranged flange (14).

21. The apparatus according to one or more of the preceding claims, **characterized in that** said cylindrical part (18) is firmly joined to said adjusting part (8).

22. The apparatus according to one or more of the preceding claims, **characterized in that** said adjusting part (8) rests against one or more grippers (3) in the region of its one end (21).

23. The apparatus according to one or more of the preceding claims, **characterized in that** said cylindrical part (18) may be placed with its one or second end or its plate (11') against a fixed flange (22) and with its first or other end or its adjusting part (8) against said gripper (3) or the lever arm (57) of said gripper (3).

24. The apparatus according to one or more of the preceding claims, **characterized in that** if differential pressure Pd occurs, said diaphragm (7) moves farther into said vacuum chamber (4) and in the process moves the gripper(s) (3) away from said bore edge (62) of said substrate (2) and releases it.

25. The apparatus according to one or more of the preceding claims, **characterized in that** said fixed flange (22) is directly or indirectly firmly joined to said flange (14) of said device (1).

26. The apparatus according to one or more of the preceding claims, **characterized in that** said fixed flange (22) has a cylindrical extension (23) in which said spring (6) is received.

27. The apparatus according to one or more of the preceding claims, **characterized in that** a support part (24) for the pivotable reception of said grippers (3) is provided between said flange (14) of said device (1) and said fixed flange (22).

28. The apparatus according to one or more of the preceding claims, **characterized in that** said fixed flange (22) and said support part (24) are releasably joined to said flange (14') of said device (1) via the same connecting elements (25) .

29. The apparatus according to one or more of the preceding claims, **characterized in that** said chamber (4') or said infeed chamber (30) located above said diaphragm (7) is evacuated via a first vacuum pump (48) and flooded via further means (32) and said chamber (4) located below said diaphragm (7) is evacuated via a second vacuum pump (27), the two vacuum pumps (48, 27) or the associated valves being controllable in such a way that the differential pressure Pd can be lowered to nearly zero.

30. The apparatus according to one or more of the preceding claims, **characterized in that** said upper chamber (4'), which is flooded via means or a control valve (32), thereby necessarily initiates the immediate displacement of said grippers (3).

31. The apparatus according to one or more of the preceding claims, **characterized in that** said gripper (3) is adjustable via a tension member that comes into action whenever the adjusting pressure corresponds to the atmospheric pressure Pₐ.

32. The apparatus according to one or more of the preceding claims, **characterized in that** said grippers (3) are on the side at which a pressure higher than the vacuum pressure Pᵥ prevails.

## Revendications

1. Dispositif de transport de substrats entre un premier dispositif (130) et au moins un deuxième dispositif (1), pour saisir et maintenir des substrats (2) à l'aide d'un ou plusieurs porte-substrats (5) disposés dans une chambre à vide (4, 4', 4"), caractérisé en ce que le premier dispositif de saisie et de maintien de substrats (2) est équipé d'un ou plusieurs préhenseurs (75) disposés de façon réglable, susceptibles d'être réglés à l'aide d'un dispositif de réglage (130) travaillant de façon mécanique et/ou électromécanique ou magnétique dans une position fixant ou libérant le substrat, le deuxième dispositif (1), orienté coaxialement par rapport au premier, destiné à la saisie et au maintien de substrats (2), étant également équipé d'un ou plusieurs préhenseurs (75) disposés de façon à pouvoir être réglés.

2. Dispositif selon la revendication 1, caractérisé en ce que les préhenseurs (75) sont réglables à l'encontre de l'effet d'une pression de réglage ou à l'encontre de l'effet d'un ressort (6), dans une première position, et par l'effet d'une membrane (7) susceptible d'être exposée à une pression pneumatique Pₐ et/ou à une pression de vide Pᵥ et d'une partie de réglage (8) coopérant avec cette membrane, dans une deuxième position, dans la première position le substrat (2) étant maintenu et dans la deuxième position le substrat (2) étant relâché pour la continuation du transport, les deux parties de logement de substrat (14, 73) étant susceptibles d'être orientées et fixées coaxialement l'une par rapport à l'autre dans la position des deuxièmes dispositifs (1, 130) assurant le transfert du substrat (2), où, après avoir effectué le positionnement coaxial et lors de la mise en appui, étanche au vide, des deux dispositifs (1, 130), la pression régnant dans la chambre d'introduction (30) étant abaissée, et le substrat (2) fourni par le premier dispositif (130) au deuxième dispositif (1) étant maintenu au moyen du deuxième dispositif (1), par l'intermédiaire de la pression exercée par le ressort qui, à présent, se libère.

3. Dispositif selon la revendication 1 ou la revendication 2, caractérisé en ce qu'entre un plateau rotatif (101) du deuxième dispositif (1) et un porte-substrat (5) est prévu un élément de liaison (145) ayant l'élasticité d'un ressort, admettant une course de déplacement.

4. Dispositif selon la revendication 1, caractérisé en ce que l'élément de liaison (145) est constitué d'une bride centrale qui est reliée, par des éléments de liaison (147), au porte-substrat (5) et, par l'intermédiaire de nervures élastiques (146), au plateau rotatif (101).

5. Dispositif selon l'une ou plusieurs des revendications précédentes, caractérisé en ce que les préhenseurs (75) associés au premier dispositif (130) sont susceptibles de pivoter à l'aide d'un élément de réglage ou d'un aimant (67) et/ou d'éléments élastiques, autour d'un axe (83), entre une position fixant le substrat (2) et une position libérant le substrat (2).

6. Dispositif selon la revendication 1, caractérisé en ce que les préhenseurs (75) associés au premier dispositif (130) sont susceptibles de pivoter autour d'un axe (83), qui coupe l'axe longitudinal (88) du préhenseur (75) ou du carter (78), sous un angle à peu près droit.

7. Dispositif selon l'une ou plusieurs des revendications précédentes, caractérisé en ce que les préhenseurs (3) associés au premier dispositif (1) réagissent déjà lors du remplissage de la chambre d'introduction (30) et les préhenseurs (3) du deuxième dispositif (1) sont réglés par les électroaimants dans une position de réception.

8. Un dispositif selon l'une ou plusieurs des revendications précédentes, caractérisé en ce que deux ou plusieurs préhenseurs (75), associés les uns aux autres à distance et appartenant au premier dispositif (130), s'engagent lors du transfert du substrat dans les espaces intermédiaires (148) des préhenseurs (3), également disposés à distance les uns les autres, du deuxième dispositif (1).

9. Dispositif selon l'une ou plusieurs des revendications précédentes, caractérisé en ce que les préhenseurs (3 ou 75) sont guidés, dans la zone d'une de leurs extrémités, dans des ouvertures en trous allongés (93) et dans la zone de leur autre extrémité, dans un carter de cylindre (81), et présentent au moins un aimant permanent (80) qui coopère avec un aimant annulaire (67).

10. Dispositif selon la revendication 9, caractérisé en ce que le carter de cylindre (81) est à parois minces et présente une épaisseur de paroi comprise entre 0,2 mm et 1,0 mm, ou 0,3 mm et 0,7 mm, ou 0,4 mm et 0,6 mm.

11. Dispositif selon l'une ou plusieurs des revendications précédentes, caractérisé en ce que les préhenseurs (75) sont logés de façon pivotante dans un palier annulaire (84) élastique et sont réglables dans la zone de leur extrémité supérieure, entre des butées (77, 77') magnétisables.

12. Dispositif selon la revendication 1, caractérisé en ce que la membrane (7), exposée à une dépression Pv à peu près constante sur une face (10), est susceptible d'être commandée par le biais d'une pression différentielle P_{d} = Pₐ - Pᵥ, qui se manifeste lorsque la chambre (30, 4', 4'') est remplie pour recevoir le substrat (2).

13. Dispositif selon la revendication 1 ou 12, caractérisé en ce que la membrane (7) est susceptible d'être commandée par l'intermédiaire de la pression atmosphérique et/ou de la pression négative du vide, ou de la pression différentielle P_{d}, résultant de la pression atmosphérique Pₐ dans la chambre d'introduction (30) moins la dépression Pᵥ dans la chambre à vide (4).

14. Dispositif selon la revendication 1, caractérisé en ce que la membrane (7) disposée dans la chambre à vide (4) est constituée d'une partie (11) flexible et d'une partie (11') non flexible, ou d'une partie métallique et/ou d'un plateau.

15. Dispositif selon l'une ou plusieurs des revendications précédentes, caractérisé en ce que la partie non flexible (11') est reliée rigidement à la partie flexible (11) de la membrane (7).

16. Dispositif selon la revendication 1, caractérisé en ce que la partie non flexible (11') est réalisée sous la forme de plateau à forme ronde circulaire, couvrant une ouverture (12) de la membrane (7).

17. Dispositif selon l'une ou plusieurs des revendications précédents, caractérisé en ce que la partie flexible (11) de la membrane (7) est raccordée rigidement par son bord extérieur (13) à une bride (14) du dispositif (1) et par le bord intérieur (15), au bord (51) de l'ouverture (12) prévue dans le plateau (11').

18. Dispositif selon l'une ou plusieurs des revendications précédentes, caractérisé en ce que la membrane (7) et le plateau (11') isolent de façon étanche la chambre (4) exposée à une dépression Pᵥ permanente, par rapport à la chambre (4') ou la chambre d'introduction (30) susceptible d'être exposée à une pression atmosphérique Pₐ.

19. Dispositif selon l'une ou plusieurs des revendications précédentes, caractérisé en ce que le bord extérieur (13) de le membrane (7) est susceptible d'être enserré et retenu dans au moins une gorge (17, 17') prévue entre la bride (14') et la partie extérieure du porte-substrat (5).

20. Dispositif selon l'une ou plusieurs des revendications précédentes, caractérisé en ce que le plateau (11) est relié ou vissé, par l'intermédiaire d'un téton (19) coaxial, à une partie (18) en forme de cylindre qui est guidée sur un téton (20) relié à une bride (14) disposée également coaxialement.

21. Dispositif selon l'une ou plusieurs des revendications précédentes, caractérisé en ce que la partie (18) en forme de cylindre est reliée rigidement à la partie de réglage (8).

22. Dispositif selon l'une ou plusieurs des revendications précédentes, caractérisé en ce que la partie de réglage (8) appuie dans la zone d'une de ses extrémités (21) contre un ou plusieurs préhenseurs (3).

23. Dispositif selon l'une ou plusieurs des revendications précédentes, caractérisé en ce que la partie (18) en forme de cylindre est susceptible d'être appliquée, par une extrémité ou une deuxième extrémité ou par son plateau (11'), contre une bride (22) stationnaire et, par sa première ou son autre extrémité, ou la partie de réglage (8), contre le préhenseur (3) ou le bras de levier (57) du préhenseur (3).

24. Dispositif selon l'une ou plusieurs des revendications précédentes, caractérisé en ce que, lorseque la pression différentielle Pd se manifeste, la membrane (7) est déplacée plus à l'intérieur de l'enceinte à vide (4) et écarte alors le ou les préhenseurs (3) du bord du perçage (62) du substrat (2) et libère celui-ci.

25. Dispositif selon l'une ou plusieurs des revendications précédentes, caractérisé en ce que la bride (22) stationnaire est reliée rigidement, indirectement ou directement, à la bride (14) du dispositif (1).

26. Dispositif selon l'une ou plusieurs des revendications précédentes, caractérisé en ce que la bride stationnaire (22) présente un prolongement (23) en forme de cylindre dans lequel le ressort (6) est logé.

27. Dispositif selon l'une ou plusieurs des revendications précédentes, caractérisé en ce qu'entre la bride (14) du dispositif (1) et la bride stationnaire (22) est prévue une partie porteuse (24) destinée à recevoir avec faculté de pivotement les préhenseurs (23).

28. Dispositif selon l'une ou plusieurs des revendications précédentes, caractérisé en ce que la bride stationnaire (22) et la partie porteuse (24) sont reliées de façon désolidarisable à la bride (14') du dispositif (1), par l'intermédiaire des mêmes éléments de liaison (25).

29. Dispositif selon l'une ou plusieurs des revendications précédentes, caractérisé en ce que la chambre (4') située au-dessus de la membrane (7) ou la chambre d'introduction (30) est évacuée, par l'intermédiaire une première pompe à vide (48), et est remplie, par l'intermédiaire d'un autre dispositif (32), et la chambre (4) située au-dessous de la membrane (7) est évacuée, par l'intermédiaire d'une deuxième pompe à vide (27), les deux pompes à vide (48, 27) ou les soupapes afférentes étant susceptibles d'être commandées de manière que la pression différentielle P_{d} puisse être abaissée à une valeur à peu près égale à zéro.

30. Dispositif selon l'une ou plusieurs des revendications précédentes, caractérisé en ce que la chambre supérieure (4') qui est remplie par l'intermédiaire d'un dispositif ou d'une soupape de commande (32) induit de ce fait obligatoirement le déplacement de réglage immédiat des préhenseurs (3).

31. Dispositif selon l'une ou plusieurs des revendications précédentes, caractérisé en ce que le préhenseur (3) est réglable par l'intermédiaire d'un élément de traction qui réagit lorsque la pression de réglage correspond à la pression atmosphérique Pₐ.

32. Dispositif selon l'une ou plusieurs des revendications précédentes, caractérisé en ce que les préhenseurs (3) se trouvent sur le côté sur lequel s'établit une pression supérieure à la dépression Pᵥ.
